# EUROPEAN PATENT APPLICATION

(11) **EP 4 811 994 A1**
(43) Date of publication of application: **23.09.2026**
(21) Application number: 24891829.4
(22) Date of filing: 14.08.2024
(51) Int. Cl.: H10K 71/70, H10K 77/10, H10K 59/121, H10K 59/131, H10D 30/67

(54) **DISPLAY DEVICE**

(30) Priority: 14.11.2023 KR 20230157099
(71) Applicant: Samsung Display Co., Ltd., Yongin-si, Gyeonggi-do 17113 (KR)
(72) Inventor: SHIN, Jae Min, Yongin-Si, Gyeonggi-do 17113 (KR); YOON, Joo Sun, Yongin-Si, Gyeonggi-do 17113 (KR)
(74) Representative: Marks & Clerk LLP
(86) International application number: PCT/KR2024/096001
(87) International publication number: WO 2025/105883

(57) **Abstract**

A display device according to an embodiment comprises: a substrate including a display area and a non-display area; a transistor disposed on the display area of the substrate and including a semiconductor layer; and at least one inspection pattern disposed on the non-display area of the substrate and including a semiconductor pattern, wherein: the inspection pattern includes a first conductive pattern and a second conductive pattern spaced apart in a thickness direction with the semiconductor pattern interposed therebetween, an inspection source electrode connected to a portion of the semiconductor pattern, and an inspection drain electrode connected to another portion of the semiconductor pattern; and the second conductive pattern is in contact with the semiconductor pattern.

## Description

### [TECHNICAL FIELD]

The present disclosure relates to a display device.

### [BACKGROUND ART]

As an information society develops, the demand for a display device for displaying an image is increasing in various forms. For example, the display device has been applied to various electronic devices such as smartphones, digital cameras, laptop computers, navigation devices, and smart televisions.

The display device may be a flat panel display device such as a liquid crystal display device, a field emission display device, or a light emitting display device. The light emitting display device includes an organic light emitting display device including an organic light emitting element, an inorganic light emitting display device including an inorganic light emitting element such as an inorganic semiconductor, and a ultra-small light emitting display device including a ultra-small light emitting element.

The organic light emitting element may include two opposing electrodes and a light emitting layer interposed therebetween. The light emitting layer receives electrons and holes from the two electrodes and recombines the electrons and the holes to generate excitons, and the generated excitons change from an excited state to a ground state, thereby emitting light.

The organic light emitting display device including the organic light emitting element may be configured in a light weight and thin shape with low power consumption because of not requiring a light source such as a backlight unit, and has also attracted attention as a next-generation display device because of having high-quality characteristics such as a wide viewing angle, high luminance and contrast, and a fast response speed.

### [DISCLOSURE]

### [TECHNICAL PROBLEM]

Aspects of the present disclosure provide a display device capable of managing characteristics of thin film transistors in a display area using an inspection pattern disposed in a non-display area.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

According to an aspect of the present disclosure, a display device comprises a substrate including a display area and a non-display area, a transistor disposed on the display area of the substrate and including a semiconductor layer, and at least one inspection pattern disposed on the non-display area of the substrate and including a semiconductor pattern, wherein the inspection pattern includes a first conductive pattern and a second conductive pattern spaced apart from each other in a thickness direction with the semiconductor pattern interposed therebetween, and an inspection source electrode connected to one portion of the semiconductor pattern and an inspection drain electrode connected to the other portion of the semiconductor pattern, and the second conductive pattern is in contact with the semiconductor pattern.

The first conductive pattern may further include a first insulating layer and a second insulating layer that are disposed on the substrate and interposed between the semiconductor pattern and the first conductive pattern.

The semiconductor pattern may include a pattern channel region, and a first conductive region and a second conductive region spaced apart from each other with the pattern channel region interposed therebetween.

The first conductive pattern may overlap the pattern channel region.

The inspection source electrode may be connected to the first conductive area, and the inspection drain electrode may be connected to the second conductive area.

The second conductive pattern may be disposed on the semiconductor pattern and may overlap the first conductive pattern.

The display device may further comprise a third insulating layer disposed between the second conductive pattern and the semiconductor pattern, wherein the second conductive pattern may be in contact with the semiconductor pattern through a first via hole penetrating through the third insulating layer.

The display device may further comprise a fourth insulating layer disposed between the inspection source electrode and the inspection drain electrode, and the second conductive pattern, wherein the inspection source electrode and the inspection drain electrode may be connected to the semiconductor pattern through a second via hole and a third via hole penetrating through the fourth insulating layer.

The display device may further comprise a fourth insulating layer disposed on the second conductive pattern, and a first inspection electrode, a second inspection electrode, a third inspection electrode, and a fourth inspection electrode may be disposed on the fourth insulating layer and spaced apart from each other.

The first inspection electrode may be connected to the first conductive pattern, and the second inspection electrode may be connected to the second conductive pattern.

The third inspection electrode may extend from the inspection source electrode, and the fourth inspection electrode may extend from the inspection drain electrode.

The semiconductor layer of the transistor in the display area may include the same material as the semiconductor pattern of the inspection pattern.

The semiconductor layer of the transistor in the display area and the semiconductor pattern of the inspection pattern may include an oxide semiconductor.

The display device may further comprise a connection pattern disposed between the first conductive pattern and the semiconductor pattern, wherein the first conductive pattern may be electrically connected to the semiconductor pattern through the connection pattern.

According to an aspect of the present disclosure, a display device comprises a substrate including a display area and a non-display area, a transistor disposed on the display area of the substrate and including a semiconductor layer, and an inspection pattern disposed on the non-display area of the substrate and including a semiconductor pattern, wherein the inspection pattern includes a first conductive pattern and a second conductive pattern spaced apart from each other in a thickness direction with the semiconductor pattern interposed therebetween, an inspection source electrode connected to one portion of the semiconductor pattern and an inspection drain electrode connected to the other portion of the semiconductor pattern, and a connection pattern disposed between the first conductive pattern and the semiconductor pattern, and the connection pattern is in contact with the first conductive pattern and the semiconductor pattern.

The semiconductor layer of the transistor in the display area and the semiconductor pattern of the inspection pattern may include an oxide semiconductor.

The display device may further comprise a first insulating layer and a second insulating layer interposed between the semiconductor pattern and the first conductive pattern, wherein the connection pattern may be disposed in a first via hole penetrating through the first insulating layer and the second insulating layer, and the first via hole may overlap the first conductive pattern and the semiconductor pattern.

The semiconductor pattern may include a pattern channel region, and a first conductive region and a second conductive region spaced apart from each other with the pattern channel region interposed therebetween, and the connection pattern may be in contact with the pattern channel region.

The first conductive pattern, the second conductive pattern, and the connection pattern may overlap the pattern channel region of the semiconductor pattern.

The display device may further comprise a third insulating layer disposed between the semiconductor pattern and the second conductive pattern, wherein the second conductive pattern may be spaced apart from the semiconductor pattern.

Other features and embodiments may be apparent from the following detailed description and the drawings.

### [ADVANTAGEOUS EFFECTS]

The display device according to an embodiment may infer the hydrogen content of a semiconductor layer of a pixel transistor in a display area by forming an inspection pattern including a semiconductor pattern in a non-display area and measuring a capacitance of the semiconductor pattern. Accordingly, the quality of the display device may be improved by monitoring the characteristics of the pixel transistors of the display device.

The effects according to the embodiments are not limited by the contents exemplified above, and more various effects are included in this disclosure.

### [DESCRIPTION OF DRAWINGS]

FIG. 1 is a plan view illustrating a display device according to an embodiment;
FIG. 2 is a plan view illustrating a display panel of FIG. 1;
FIG. 3 is a circuit diagram illustrating a pixel according to an embodiment;
FIG. 4 is a circuit diagram illustrating a pixel PX according to an embodiment;
FIG. 5 is a cross-section view illustrating a display panel 110 according to an embodiment;
FIG. 6 is a plan view illustrating an inspection pattern according to an embodiment;
FIG. 7 is a cross-sectional view taken along line Q1-Q1' of FIG. 6;
FIG. 8 is a graph illustrating changes in characteristics of a transistor depending on a hydrogen content of a semiconductor layer;
FIG. 9 is a graph illustrating changes in characteristics of a transistor having a semiconductor layer without hydrogen.
FIG. 10 is a graph illustrating changes in characteristics of a transistor having a semiconductor layer containing hydrogen;
FIG. 11 is a graph illustrating a capacitance of a semiconductor pattern according to frequency;
FIG. 12 is a cross-sectional view illustrating an inspection pattern of a display device according to another embodiment;
FIG. 13 is a cross-sectional view illustrating an inspection pattern of a display device according to still another embodiment; and
FIG. 14 is a plan view illustrating a display panel according to still another embodiment.

### [MODES OF THE INVENTION]

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

Although terms such as first, second, etc. are used to describe various components, these components are not limited by these terms. These terms are merely used to distinguish one component from another. Thus, a first component mentioned below may also be a second component within the technical spirit of the present invention.

Hereinafter, embodiments of the present disclosure will be described with reference to the drawings.

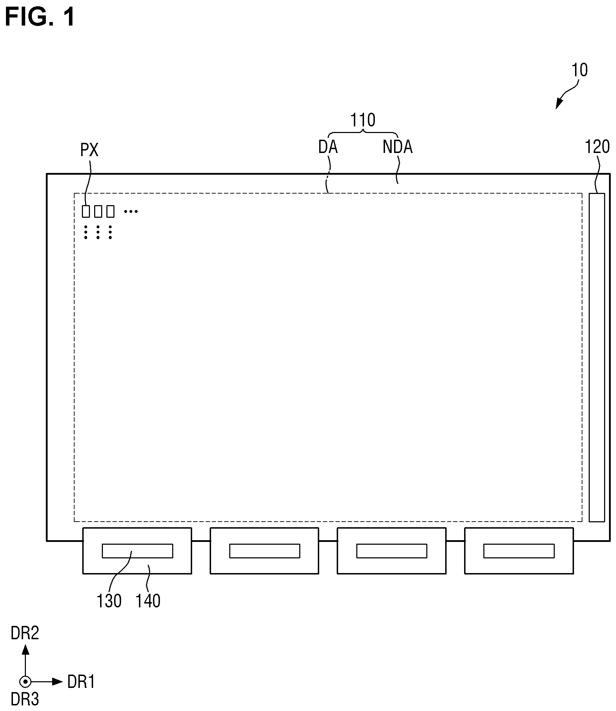

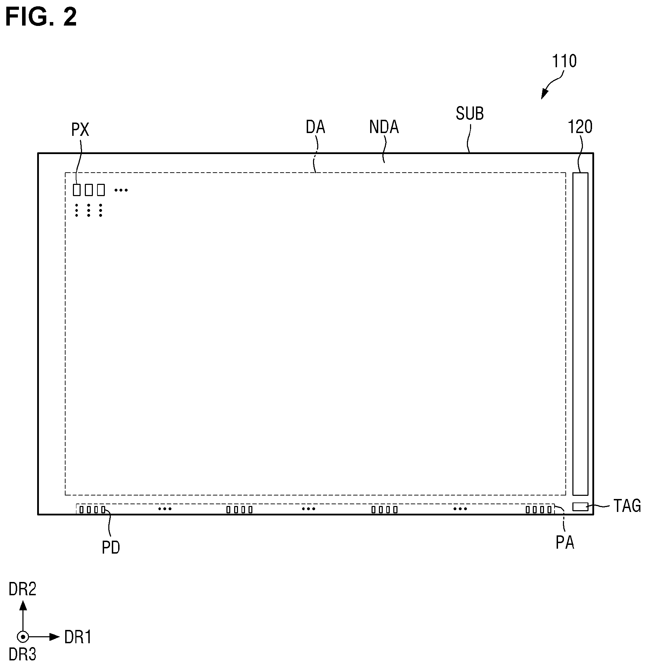

FIG. 1 is a plan view illustrating a display device according to an embodiment. FIG. 2 is a plan view illustrating a display panel of FIG. 1.

Referring to FIGS. 1 and 2, a display device 10 is a device that displays a moving image or a still image, and may be used as a display screen of each of various products such as a television, a laptop computer, a monitor, a billboard, and an Internet of Things (IOT) device as well as portable electronic devices such as a mobile phone, a smartphone, a tablet personal computer (PC), a smartwatch, a watch phone, a mobile communication terminal, an electronic organizer, an electronic book, a portable multimedia player (PMP), a navigation device, and an ultra mobile PC (UMPC). These are presented merely as examples, and the display device 10 may also be employed in other electronic devices.

In an embodiment, the display device 10 may be a light emitting display device such as an organic light emitting display device using an organic light emitting diode, a quantum dot light emitting display device including a quantum dot light emitting layer, an inorganic light emitting display device including an inorganic semiconductor, and a micro or nano light emitting display device using a micro or nano light emitting diode (LED), but is not limited thereto. For example, the display device 10 may be a type of display device other than the light emitting display device. Hereinafter, embodiments in which the display device 10 is an organic light emitting display device will be disclosed.

The display device 10 may include a display panel 110 including pixels PX, and a first driver 120 and a second driver 130 that supply driving signals to the pixels PX. The display device 10 may further include additional components. For example, the display device 10 may further include a power supply unit for supplying power voltages to the pixels PX, the first driver 120, and the second driver 130, a timing control unit for controlling operations of the first driver 120 and the second driver 130.

The display panel 110 may include a display area DA and a non-display area NDA. The display area DA may be an area that includes the pixels PX and displays an image. The non-display area NDA is the remaining area excluding the display area DA, and an image may not be displayed in the non-display area NDA. In an embodiment, the non-display area NDA may be positioned around the display area DA and surround the display area DA.

In FIGS. 1 and 2, a first direction DR1, a second direction DR2, and a third direction DR3 may be defined. In an embodiment, the first direction DR1 and the second direction DR2 may be perpendicular to each other, the first direction DR1 and the third direction DR3 may be perpendicular to each other, and the second direction DR2 and the third direction DR3 may be perpendicular to each other. For example, the first direction DR1 may be a horizontal direction of the display panel 110, and the second direction DR2 may be a vertical direction of the display panel 110. The third direction DR3 may be a thickness direction of the display panel 110.

In an embodiment, the display panel 110 may have a rectangular shape in plan view. For example, the display panel 110 may include two first sides extending in the first direction DR1 and two second sides extending in the second direction DR2 intersecting the first direction DR1. FIGS. 1 and 2 illustrate a display panel 110 in which the first side in the horizontal direction is longer than the second side in the vertical direction, but the shape of the display panel 110 is not limited thereto. For example, the display panel 110 may also have a shape in which the second side in the vertical direction is longer than the first side in the horizontal direction, or a shape in which the first and second sides have substantially the same length.

In an embodiment, the display panel 110 may include an angled corner at a portion where the first side and the second side meet, but is not limited thereto. For example, the display panel 110 may also include a rounded corner at a portion where the first side and the second side meet.

The planar shape of the display panel 110 is not limited to the illustrated rectangular shape, and other shapes may also be applied. For example, the display panel 110 may have a square shape, a non-quadrangular other polygonal shape, a circular shape, an oval shape, an irregular shape, or another shape in plan view.

In an embodiment, the display panel 110 may be substantially flat on a plane defined by the first direction DR1 and the second direction DR2 and may have a uniform thickness in the third direction DR3. In another embodiment, the display panel 110 may also be provided in a three-dimensional shape having a curved surface, etc.

The display panel 110 may be provided as a panel with rigid characteristics so as not to be substantially deformed, or may be provided as a flexible panel that may be deformed into a shape such as being folded, bent, or rolled at least in one portion. The display panel 110 may be provided to the display device 10 in an unbent state or may be provided in a bent state in some sections.

The display panel 110 may include a substrate SUB and pixels PX disposed on the substrate SUB. The pixels PX may be disposed in the display area DA on the substrate SUB.

The substrate SUB is a base member for manufacturing or providing the display panel 110 and may form a base surface of the display panel 110. The substrate SUB may include a display area DA and a non-display area NDA positioned around the display area DA.

The display area DA may have various shapes depending on embodiments. For example, the display area DA may have a square shape, a non-quadrangular other polygonal shape, a circular shape, an oval shape, an irregular shape, or another shape. In an embodiment, the display area DA may have a shape that matches the shape of the display panel 110, but is not limited thereto.

The display area DA may include pixel areas in which the pixels PX are provided and/or disposed. For example, each pixel PX may be disposed in each pixel area positioned in the display area DA. In an embodiment, the display device 10 may be a light emitting display device, and each pixel PX may include a light emitting element positioned in each light emitting area and a pixel circuit connected to the light emitting element. In describing the embodiments, "connection" may include electrical connection and/or physical connection.

In each pixel area, a light emitting element of the corresponding pixel is positioned, and each pixel area may include a light emitting area in which the pixel emits light, and a pixel circuit area in which circuit elements constituting a pixel circuit of the corresponding pixel are positioned. In an embodiment, the light emitting area and the pixel circuit area of each pixel PX may overlap each other, but are not limited thereto.

The pixels PX may be arranged in the display area DA. For example, the pixels PX may be arranged in the display area DA in a stripe structure, delta structure, PenTile^{™} structure, or other arrangement structure.

The non-display area NDA may include a driving circuit area positioned on at least one side of the display area DA and a pad area PA in which pads PD are disposed. At least one driver, pads PD, and/or lines may be disposed in the non-display area NDA.

At least one driver for driving the pixels PX, or a portion of the driver, may be disposed in the driving circuit area. As an example, circuit elements constituting the first driver 120 may be disposed in the driving circuit area on the substrate SUB. In an embodiment, the circuit elements of the first driver 120 may be formed in the display panel 110 together with the pixels PX.

The pads PD may be disposed in the pad area PA. At least one circuit board 140 may be disposed and/or bonded onto the pad area PA. In an embodiment, a plurality of circuit boards 140 connected to different pads PD may be disposed on the pad area PA. The pads PD may include signal pads and power pads for transmitting driving signals and power voltages necessary for driving the pixels PX and/or the first driver 120 to the inside of the display panel 110.

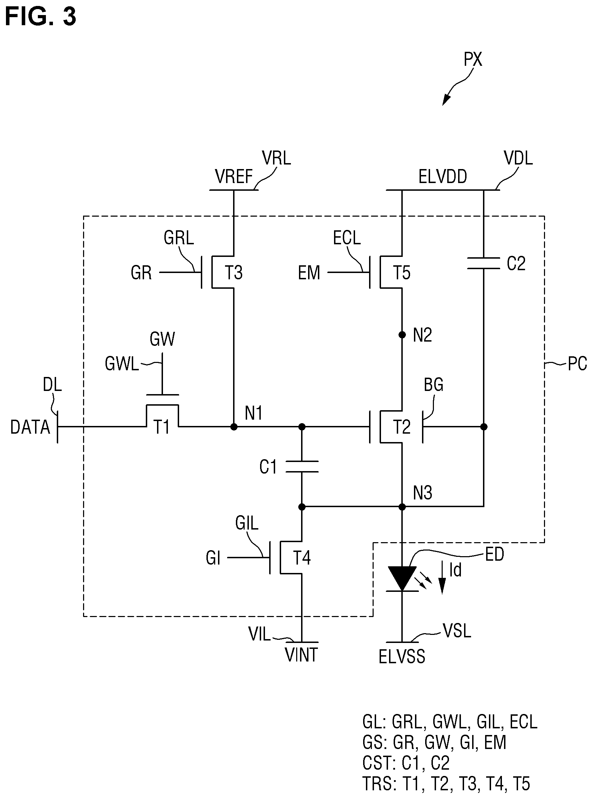

The first driver 120 and the second driver 130 may generate driving signals for controlling an operation timing and luminance of the pixels PX, and supply the driving signals to the pixels PX. For example, the first driver 120 may be a gate driver including a scan driver, and may be connected to the pixels PX through respective gate line. The first driver 120 may supply respective gate signals (e.g., driving signals that control the operation timing of the pixels PX, including a first gate signal GW in FIG. 3) to the pixels PX. The second driver 130 may be a data driver including source driver circuits and may be connected to the pixels PX through respective data lines. The second driver 130 may supply respective data signals to the pixels PX.

In an embodiment, at least one of the first driver 120 and the second driver 130, or a portion of the at least one driver, may be built into the display panel 110. For example, the first driver 120 or a portion of the first driver 120 may be disposed on the substrate SUB of the display panel 110 and may be disposed and/or formed in the non-display area NDA.

It is illustrated in FIG. 1 that the first driver 120 is formed on one side of the display area DA (e.g., the non-display area NDA on the right side of the display area DA), but the embodiments are not limited thereto. For example, the first driver 120 may be positioned only on the other side of the display area DA (e.g., the non-display area NDA on the left side of the display area DA), or may be positioned on both sides of the display area DA (e.g., non-display areas NDA on the left and right sides of the display area DA). Alternatively, a portion of the first driver 120 (e.g., some of the circuit elements constituting the first driver 120) may be positioned in the non-display area NDA, and the other portion of the first driver 120 (e.g., remaining circuit elements of the circuit elements constituting the first driver 120) may be positioned in a non-light emitting area (e.g., an area between light emitting areas of the pixels PX) within the display area DA.

In an embodiment, the other of the first driver 120 and the second driver 130, or a portion of the other driver, may be disposed or formed outside the display panel 110 and may be electrically connected to the display panel 110. For example, the second driver 130 or a portion of the second driver 130 may be implemented with a plurality of integrated circuit chips and may be disposed on the circuit board 140 electrically connected to the pixels PX of the display panel 110. In an embodiment, the second driver 130 may be integrated into an integrated circuit chip separate from the timing control unit, or may be integrated into each integrated circuit chip together with the timing control unit. The second driver 130 may be implemented with at least one integrated circuit chip and may be mounted on the non-display area NDA of the display panel 110.

The circuit board 140 may be connected to the display panel 110 through pads PD. In an embodiment, the circuit board 140 may be a flexible film such as a flexible printed circuit board (FPCB), a printed circuit board (PCB), or a chip on film (COF), but is not limited thereto. In an embodiment, the circuit board 140 may be connected to the timing control unit and/or the power supply unit through another circuit board or a connector.

In an embodiment, an inspection pattern TAG may be disposed in the non-display area NDA. The inspection pattern TAG is used to inspect the characteristics of the thin film transistor, and an inspection may be performed by connecting a measuring device to the inspection pattern TAG. Accordingly, the hydrogen content of the thin film transistor, etc. may be inferred by inspecting the characteristics of the thin film transistor from the inspection pattern TAG. Through this, quality of the display device may be improved through process evaluation and compensation.

At least one inspection pattern TAG may be disposed in the non-display area NDA. For example, the inspection pattern TAG may be disposed in a space between the first driver 120 and the pad area PA. In some embodiments, a plurality of inspection patterns TAG may also be disposed.

The inspection pattern TAG may be used to infer the characteristics of the thin film transistors in the display area DA, for example, the hydrogen content of the semiconductor layer. Since the inspection pattern TAG is disposed in the non-display area NDA, the inspection pattern TAG remains even after the display device 10 is completed. Accordingly, the thin film transistors may be evaluated not only during the manufacturing process of the display device, but also after the display device is completed, and the quality of the display device 10 may be improved through compensation accordingly. The inspection pattern TAG will be described in detail later.

FIG. 3 is a circuit diagram illustrating a pixel according to an embodiment. The pixel PX in FIG. 3 is presented as merely one example, and the structure or type of the pixel PX may vary depending on the embodiments.

Referring to FIG. 3 in addition to FIGS. 1 and 2, the pixel PX may include a light emitting element ED and a pixel circuit PC connected to the light emitting element ED. The light emitting element ED is a light source of the pixel PX and may be, for example, an organic light emitting diode, but is not limited thereto. The pixel circuit PC may control the light emitting timing and luminance of the light emitting element ED.

The pixel circuit PC may include pixel transistors TRS and at least one pixel capacitor CST. For example, the pixel circuit PC may include first to fifth transistors T1 to T5, and first and second capacitors C1 and C2. The structure of the pixel circuit PC or the types of circuit elements constituting the pixel circuit PC may be variously changed depending on the embodiments. FIG. 3 illustrates an embodiment in which the pixel transistors TRS are N-type transistors, but the type of pixel transistors TRS is not limited thereto. For example, at least one pixel transistor TRS may also be formed as a P-type transistor.

The pixel circuit PC may supply a driving current Id to the light emitting element ED in response to the driving signals supplied from the first driver 120 and the second driver 130. For example, the pixel circuit PC may supply the driving current Id to the light emitting element ED in response to each gate signal GS supplied from the first driver 120 through each gate line GL, and a data signal DATA supplied from the second driver 130 through the data line DL.

The second transistor T2 may be a driving transistor of the pixel PX whose size of a drain-source current (e.g., a driving current Id) is determined depending on a gate-source voltage. The first, third, fourth, and fifth transistors T1, T3, T4, and T5 may be switching transistors that are turned on or off depending on respective gate-source voltages (substantially, respective gate voltages). Depending on the type (e.g., P-type or N-type transistor) and/or operating conditions of each of the first to fifth transistors T1 to T5, a first electrode of each of the first to fifth transistors T1 to T5 may be a drain electrode (or a drain region) or a source electrode (or source region), and a second electrode thereof may be an electrode different from the first electrode. For example, when the first electrode is a drain electrode, the second electrode may be a source electrode.

The pixel PX may be connected to a first gate line GWL transmitting a first gate signal GW (e.g., a scan signal), a second gate line GIL transmitting a second gate signal GI, a third gate line GRL transmitting a third gate signal GR, an emission control line ECL transmitting an emission control signal EM, and a data line DL transmitting a data signal DATA. In addition, the pixel PX may be connected to a first pixel power line VDL transmitting a first pixel voltage ELVDD (also referred to as "first pixel power voltage"), and a second pixel power line VSL transmitting a second pixel voltage ELVSS (also referred to as "second pixel power voltage"). In an embodiment, the pixel PX may be further connected to an initialization power line VIL transmitting an initialization voltage VINT (also referred to as "third pixel power voltage"), and a reference power line VRL transmitting a reference voltage VREF (also referred to as "fourth pixel power voltage").

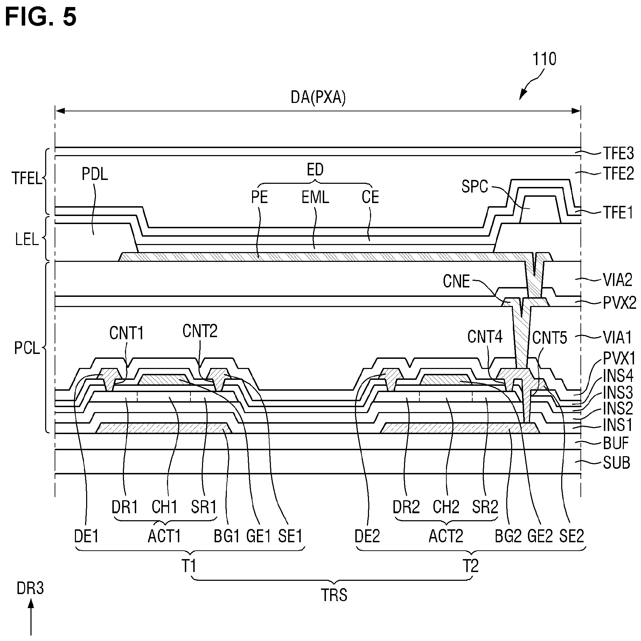

In an embodiment, the first to fifth transistors T1 to T5 may be positioned in each pixel area (e.g., a pixel area PXA of one pixel PX provided in the display area DA in FIG. 5), and may be oxide transistors (also referred to as "oxide semiconductor transistors") including an oxide semiconductor (e.g., an oxide semiconductor material). For example, a semiconductor layer of each of the first to fifth transistors T1 to T5 may be formed of an oxide semiconductor. However, the embodiments are not limited thereto. For example, at least one pixel transistor TRS may also be formed of a semiconductor material (e.g., amorphous silicon or polysilicon) other than the oxide semiconductor.

The oxide semiconductor may have high carrier mobility (e.g., high electron mobility in the case of an N-type transistor) and low leakage current, and accordingly, even if a driving time of the oxide transistor becomes longer, a voltage drop may not significantly occur. For example, the pixel PX including the oxide transistor may be driven at a low frequency because the luminance and/or color of an image does not change significantly due to a voltage drop even when driven at the low frequency. In the case of the display device 10 in which the first to fifth pixel transistors T1 to T5 include the oxide semiconductor, leakage current of the pixel PX may be reduced or prevented and power consumption may be reduced.

Since the oxide semiconductor is sensitive to light, the amount of current, etc. may vary due to external light. In an embodiment, a light blocking pattern or a lower electrode (e.g., bottom gate electrode) may be disposed below the semiconductor layer constituting at least one pixel transistor TRS (e.g., at least one of the first to fifth pixel transistors T1 to T5). Accordingly, it is possible to prevent or reduce the variation in the amount of current of the pixel transistor TRS due to light, and to stabilize operating characteristics of the pixel transistor TRS.

The first transistor T1 (also referred to as "first pixel transistor") may include a gate electrode connected to the first gate line GWL, a first electrode connected to the data line DL, and a second electrode connected to a first node N1. The first transistor T1 may be turned on by the first gate signal GW (e.g., the first gate signal GW of a gate-on voltage) transmitted to the first gate line GWL and connect the data line DL and the first node N1 to each other. Accordingly, the data signal DATA transmitted to the data line DL may be transmitted to the first node N1.

The second transistor T2 (also referred to as "second pixel transistor") may include a gate electrode connected to the first node N1 (or gate node), a first electrode (e.g., drain electrode or drain region) connected to a second node N2, and a second electrode (e.g., source electrode or source region) connected to a third node N3. The first electrode of the second transistor T2 may be connected to the first pixel power line VDL via the fifth transistor T5, and the second electrode thereof may be connected to the light emitting element ED. The second transistor T2 may function as a driving transistor of the pixel PX, and may control the size (e.g., amount of current) of the driving current Id flowing to the light emitting element ED in response to the data signal DATA transmitted according to a switching operation of the first transistor T1.

In an embodiment, the second transistor T2 may further include a bottom gate electrode BG (also referred to as "back-gate electrode of the second transistor T2" or "second bottom gate electrode") connected to the third node N3. When the second transistor T2 is formed as a transistor with a double gate structure (e.g., a double gate transistor with a source-sink structure) by connecting the bottom gate electrode BG of the second transistor T2 to the third node N3 to which the second electrode (e.g., source electrode) of the second transistor T2 is connected, operating characteristics of the second transistor T2 may be improved.

The third transistor T3 (also referred to as "third pixel transistor") may include a gate electrode connected to the third gate line GRL, a first electrode connected to the reference power line VRL, and a second electrode connected to the first node N1. The third transistor T3 may be turned on by the third gate signal GR transmitted to the third gate line GRL and transmit the reference voltage VREF transmitted to the reference power line VRL to the first node N1.

The fourth transistor T4 (also referred to as "fourth pixel transistor") may include a gate electrode connected to the second gate line GIL, a first electrode connected to the third node N3, and a second electrode connected to the initialization power line VIL. The fourth transistor T4 may be turned on by the second gate signal GI transmitted to the second gate line GIL and transmit the initialization voltage VINT transmitted to the initialization power line VIL to the third node N3.

The fifth transistor T5 (also referred to as "fifth pixel transistor") may include a gate electrode connected to the emission control line ECL, a first electrode connected to the first pixel power line VDL, and a second electrode connected to the second node (or the first electrode of the second transistor T2). The fifth transistor T5 may be turned on by the emission control signal EM (e.g., an emission control signal EM of a gate-on voltage) transmitted to the emission control line ECL and control a light emitting timing of the pixel PX.

The first capacitor C1 may be connected between the first node N1 and the third node N3. For example, the first capacitor C1 may be connected between the gate electrode and the second electrode of the second transistor T2. The first capacitor C1 is a storage capacitor of the pixel PX and may store a threshold voltage of the second transistor T2 and a voltage corresponding to the data signal DATA (e.g., data voltage).

The second capacitor C2 may be connected between the first pixel power line VDL and the third node N3. In an embodiment, the capacity of the second capacitor C2 may be smaller than the capacity of the first capacitor C1.

The light emitting element ED may be connected between the third node N3 and the second pixel power line VSL. For example, the light emitting element ED may include a first electrode (e.g., an anode electrode or a pixel electrode) connected to the third node N3, a second electrode (e.g., a cathode electrode or a counter electrode) facing the first electrode and connected to the second pixel power line VSL, and a light emitting layer interposed between the first electrode and the second electrode. In an embodiment, the first electrode of the light emitting element ED may be an individual electrode provided individually to each pixel PX, and the second electrode of the light emitting element ED may be a common electrode shared by the plurality of pixels PX. The light emitting element ED may emit light with a luminance corresponding to the driving current Id while the driving current Id is supplied from the pixel circuit PC.

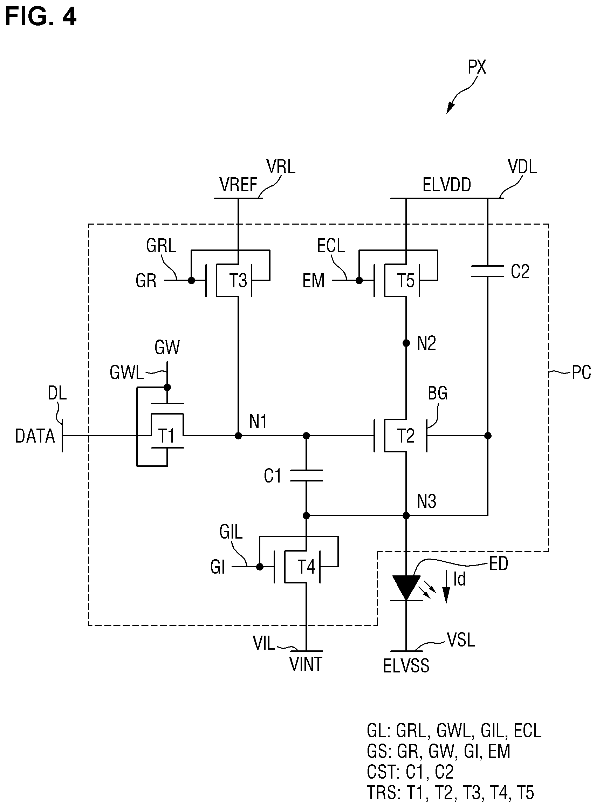

FIG. 4 is a circuit diagram illustrating a pixel PX according to an embodiment. For example, FIG. 4 illustrates an additional embodiment related to the switching transistors among the pixel transistors TRS of FIG. 3.

Referring to FIG. 4 in addition to FIGS. 1 to 3, at least one of the switching transistors provided in the pixel PX may include a bottom gate electrode BG (or back-gate electrode) facing a gate electrode (e.g., a top gate electrode) with a semiconductor layer interposed therebetween. For example, at least one of the first, third, fourth, and fifth transistors T1, T3, T4, and T5 may include a bottom gate electrode BG.

FIG. 4 discloses an embodiment in which the respective bottom gate electrodes BG are provided to all pixel transistors TRS, and a reference symbol will be used only for the bottom gate electrode BG provided to one pixel transistor TRS (e.g., the second transistor T2). However, the embodiments are not limited thereto. For example, at least one pixel transistor TRS may not include the bottom gate electrode BG and/or may not be formed in a gate-sink structure or a source-sink structure.

In an embodiment, the first, third, fourth, and fifth transistors T1, T3, T4, and T5 may include the respective bottom gate electrodes BG. In an embodiment, the bottom gate electrode BG of each of the first, third, fourth, and fifth transistors T1, T3, T4, and T5 may be connected to the gate electrode of the corresponding pixel TRS. For example, each of the first, third, fourth, and fifth transistors T1, T3, T4, and T5 may be formed as a double gate transistor with a gate-sink structure.

By providing the respective bottom gate electrodes BG to the first, third, fourth, and fifth transistors T1, T3, T4, and T5, it is possible to prevent or reduce variation in the amount of current of the first, third, fourth, and fifth transistors T1, T3, T4, and T5 due to light. In addition, when the bottom gate electrode BG of each of the first, third, fourth and fifth transistors T1, T3, T4 and T5 is connected to the gate electrode (also referred to as "top gate electrode") of each of the first, third, fourth and fifth transistors T1, T3, T4 and T5, operating characteristics (e.g., switching characteristics) of each of the first, third, fourth, and fifth transistors T1, T3, T4, and T5 may be improved and/or stabilized. For example, by forming at least one switching transistor in the double gate structure of the gate-sink structure, off characteristics and switching speed of the switching transistor may be improved, an additional voltage tolerance range may be secured, leakage current may be reduced, and voltage stability may be improved. As an example, by forming a small-sized switching transistor formed as an oxide transistor with a short channel length in a double gate structure such as a gate-sink structure, the operating characteristics of the switching transistor may be improved.

FIG. 5 is a cross-section view illustrating a display panel 110 according to an embodiment.

FIG. 5 illustrates the first transistor T1 and the second transistor T2 disposed in any one pixel area PXA, as an example of circuit elements that may be provided or disposed in the panel circuit layer PCL of the display panel 110. In addition, FIG. 5 illustrates a light emitting display panel including an emitting element ED (e.g., an organic light emitting diode), as an example of the display panel 110 to which the embodiments may be applied. However, the types and/or structures of the display panel 110 according to the embodiments are not limited thereto. For example, the display panel 110 may include a light emitting element of another type and/or structure, or may be a display panel of other types and/or structures other than the light emitting display panel.

Referring to FIG. 5 together with FIGS. 1 to 4, the display panel 110 may include a substrate SUB, a panel circuit layer PCL, a light emitting element layer LEL and a thin film encapsulation layer TFEL. The panel circuit layer PCL, the light emitting element layer LEL, and the thin film encapsulation layer TFEL may be disposed or provided to overlap each other on the substrate SUB. As an example, based on the display area DA, the panel circuit layer PCL, the light emitting element layer LEL, and the thin film encapsulation layer TFEL may be sequentially disposed or formed on the substrate SUB along the third direction DR3. However, the embodiments are not limited thereto, and the mutual position of the panel circuit layer PCL, the light emitting element layer LEL, and the thin film encapsulation layer TFEL may be changed. As an example, the panel circuit layer PCL and the light emitting element layer LEL may be integrated with each other, or the light emitting element layer LEL may be disposed on an upper side of the panel circuit layer PCL.

In an embodiment, the display panel 110 may further include additional elements provided on the upper and lower sides of the thin film encapsulation layer TFEL. For example, the display panel 110 may further include at least one of a sensor layer (e.g., a touch sensor layer), an optical layer (e.g., a color filter layer and/or a wavelength conversion layer), and a protective layer (e.g., a protective film, an insulating layer, an upper substrate, and/or a window). Each of the sensor layer, the optical layer, and/or the protective layer may be provided on the upper side of the thin film encapsulation layer TFEL or may be provided between the light emitting element layer LEL and the thin film encapsulation layer TFEL. In an embodiment, the sensor layer, the optical layer, and/or the protective layer may be provided on the display panel 110. For example, the sensor layer, the optical layer, and/or the protective layer may be manufactured integrally with the display panel 110. In another embodiment, the sensor layer, the optical layer, and/or the protective layer may be manufactured separately from the display panel 110 and attached to the display panel 110 through an adhesive layer or the like.

The substrate SUB is a base member for forming the display panel 110 and may be a substrate (or film) having rigid or flexible characteristics. In an embodiment, the substrate SUB may be a substrate that includes an insulating material such as glass and has rigid characteristics and may not be bent. In another embodiment, the substrate SUB may be a flexible substrate that includes polyimide or another insulating material and is capable of deformation such as bending, folding, or rolling, and may or may not be bent. The type and/or material of the substrate SUB may be changed depending on the embodiments.

The substrate SUB may include at least a display area DA. In an embodiment, the display area DA may include pixel areas PXA each corresponding to the pixels PX. For example, in the display area DA, each pixel area PXA in which each pixel PX is disposed may be defined.

In an embodiment, a buffer layer BUF may be disposed on the substrate SUB. In another embodiment, the display panel 110 may not include the buffer layer BUF, and in this case, the panel circuit layer PCL may be disposed directly on the substrate SUB.

The buffer layer BUF may include at least one inorganic insulating layer including an inorganic insulating material (e.g., silicon nitride, silicon oxide, silicon oxynitride, titanium oxide, aluminium oxide, or other inorganic insulating materials). The buffer layer BUF may protect the pixels PX from moisture permeating through the substrate SUB that is vulnerable to moisture permeation. The material of the buffer layer BUF may be variously changed depending on the embodiments.

The panel circuit layer PCL may be disposed on the buffer layer BUF. The panel circuit layer PCL may include circuit elements including pixel transistors TRS and a pixel capacitor CST, and lines (e.g., signal lines and power lines).

The panel circuit layer PCL may further include insulating layers disposed on the substrate SUB. For example, the panel circuit layer PCL may include a first insulating layer INS1, a second insulating layer INS2, a third insulating layer INS3, a fourth insulating layer INS4, and a first passivation layer PVX1 that are sequentially disposed on the substrate SUB along the third direction DR3.

In an embodiment, the panel circuit layer PCL may further include a connection electrode CNE and a second passivation layer PVX2 disposed on the first passivation layer PVX1 as illustrated in FIG. 5.

In an embodiment, each of the first insulating layer INS1, the second insulating layer INS2, the third insulating layer INS3, and the fourth insulating layer INS4 may include at least one inorganic insulating layer including an inorganic insulating material (e.g., silicon nitride, silicon oxide, silicon oxynitride, titanium oxide, aluminium oxide, or other inorganic insulating materials).

Each of a first via layer VIA1 and a second via layer VIA2 may include at least one organic insulating layer including an organic insulating material (e.g., acrylic resin, epoxy resin, phenolic resin, polyamide resin, polyimide resin, or other organic insulating materials). Surfaces (e.g., upper surfaces) of the first via layer VIA1 and the second via layer VIA2 may be substantially flat. The type, material, shape, and/or structure of the insulating layers provided on the panel circuit layer PCL may be variously changed depending on the embodiments.

The pixel transistors TRS may be included in the pixel circuit PC of each pixel PX and may be positioned in the display area DA. For example, the first transistor T1 and the second transistor T2 provided to each pixel PX may be disposed in each pixel area PXA in which the corresponding pixel PX is positioned. In addition, at least one other pixel transistor TRS and/or at least one pixel capacitor CST may be further disposed in each pixel area PXA.

In an embodiment, at least one pixel transistor TRS may include a bottom gate electrode BG. For example, the first transistor T1 may include a first bottom gate electrode BG1, and the second transistor T2 may include a second bottom gate electrode BG2. In an embodiment, the first bottom gate electrode BG1 and the second bottom gate electrode BG2 may be disposed on the same layer in the panel circuit layer PCL.

The first transistor T1 may include a first bottom gate electrode BG1 disposed on the substrate SUB, a first semiconductor layer ACT1 disposed on the first bottom gate electrode BG1 and including a first channel region CH1, a first drain region DR1, and a first source region SR1, and a first gate electrode GE1 (hereinafter, referred to as "first top gate electrode GE1") disposed on the first semiconductor layer ACT1.

The first semiconductor layer ACT1 may be disposed on at least a portion of the first bottom gate electrode BG1. For example, at least a portion of the first semiconductor layer ACT1 including the first channel region CH1 may overlap the first bottom gate electrode BG1. The first top gate electrode GE1 may be disposed on a portion of the first semiconductor layer ACT1 including the first channel region CH1, and the third insulating layer INS3 may be disposed between the first top gate electrode GE1 and the first semiconductor layer ACT1.

In an embodiment, the first transistor T1 may further include a first drain electrode DE1 and a first source electrode SE1 connected to different portions of the first semiconductor layer ACT1. Alternatively, the first transistor T1 does not include a separate drain electrode and/or source electrode, and the first drain region DR1 and/or the first source region SR1 of the first semiconductor layer ACT1 may be connected to other circuit elements, lines, and/or conductive patterns to function as the drain electrode and/or source electrode of the first transistor T1.

The first bottom gate electrode BG1 may be disposed between the substrate SUB and the first insulating layer INS1. For example, the first bottom gate electrode BG1 may be disposed on the buffer layer BUF and covered by the first insulating layer INS1.

The first bottom gate electrode BG1 may overlap the first semiconductor layer ACT1. For example, the first bottom gate electrode BG1 may be disposed on a lower side of the first semiconductor layer ACT1 to at least overlap the first channel region CH1. The first insulating layer INS1 and the second insulating layer INS2 may be disposed between the first bottom gate electrode BG1 and the first semiconductor layer ACT1. The first bottom gate electrode BG1 and the first semiconductor layer ACT1 may be spaced apart from each other by a distance corresponding to thicknesses of the first insulating layer INS1 and the second insulating layer INS2. The first bottom gate electrode BG1 may face the first top gate electrode GE1 with the first semiconductor layer ACT1 interposed therebetween.

The first bottom gate electrode BG1 may or may not be connected to another electrode of the first transistor T1. In an embodiment, the first bottom gate electrode BG1 may be electrically connected to the first top gate electrode GE1 and may be utilized as a back-gate electrode for adjusting the characteristics of the first transistor T1.

The first semiconductor layer ACT1 may be disposed on the second insulating layer INS2. In an embodiment, the first semiconductor layer ACT1 may be disposed on the second insulating layer INS2 and may be covered by the third insulating layer INS3.

The first semiconductor layer ACT1 may include a first channel region CH1 overlapping the first top gate electrode GE1, and a first drain region DR1 and a first source region SR1 spaced apart from each other with the first channel region CH1 interposed therebetween. For example, the first drain region DR1 and the first source region SR1 may be positioned on both sides of the first channel region CH1. The first channel region CH1 may be a region that is not conductive and maintains semiconductor properties, and the first drain region DR1 and the first source region SR1 may be conductive regions.

The first semiconductor layer ACT1 may overlap the first bottom gate electrode BG1 and the first top gate electrode GE1. For example, the first channel region CH1 of the first semiconductor layer ACT1 may be disposed between the first bottom gate electrode BG1 and the first top gate electrode GE1, and may overlap the first bottom gate electrode BG1 and the first top gate electrode GE1.

The first semiconductor layer ACT1 may be entirely covered by the third insulating layer INS3. For example, the first semiconductor layer ACT1 may be covered by the third insulating layer INS3 except for a portion where at least one contact hole (e.g., a first contact hole CNT1 and a second contact hole CNT2) is formed for connection to the first drain electrode DE1 and/or the first source electrode SE1. Accordingly, as the amount of hydrogen flowing into the first semiconductor layer ACT1 during the process of forming the panel circuit layer PCL is reduced, conductivity (e.g., carrier concentration) of the first semiconductor layer ACT1 and/or a formation length of the first channel region CH1 may be appropriately controlled.

The first top gate electrode GE1 may be disposed on the third insulating layer INS3. In an embodiment, the first top gate electrode GE1 may be disposed on the third insulating layer INS3 and covered by the fourth insulating layer INS4.

The first top gate electrode GE1 may be disposed on the first semiconductor layer ACT1 to overlap the first channel region CH1. The first top gate electrode GE1 and the first semiconductor layer ACT1 may be spaced apart from each other with the third insulating layer INS3 interposed therebetween.

The first drain electrode DE1 and the first source electrode SE1 may be disposed on the fourth insulating layer INS4. The first drain electrode DE1 may be connected to a portion of the first semiconductor layer ACT1. For example, the first drain electrode DE1 may be connected to the first drain region DR1 through the first contact hole CNT1 penetrating through the third insulating layer INS3 and the fourth insulating layer INS4. The first source electrode SE1 may be connected to another portion of the first semiconductor layer ACT1. For example, the first source electrode SE1 may be connected to the first source region SR1 through the second contact hole CNT2 penetrating through the third insulating layer INS3 and the fourth insulating layer INS4.

The second transistor T2 may include a second bottom gate electrode BG2 disposed on the substrate SUB, a second semiconductor layer ACT2 disposed on the second bottom gate electrode BG2 and including a second channel region CH2, a second drain region DR2, and a second source region SR2, and a second gate electrode GE2 (hereinafter, referred to as "second top gate electrode GE2") disposed on the second semiconductor layer ACT2. The second semiconductor layer ACT2 may be disposed on at least a portion of the second bottom gate electrode BG2. For example, at least a portion of the second semiconductor layer ACT2 including the second channel region CH2 may overlap the second bottom gate electrode BG2. The second top gate electrode GE2 may be disposed on a portion of the second semiconductor layer ACT2 including the second channel region CH2, and the third insulating layer INS3 may be disposed between the second top gate electrode GE2 and the second semiconductor layer ACT2.

In an embodiment, the second transistor T2 may further include a second drain electrode DE2 and a second source electrode SE2 connected to different portions of the second semiconductor layer ACT2. Alternatively, the second transistor T2 does not include a separate drain electrode and/or source electrode, and the second drain region DR2 and/or the second source region SR2 of the second semiconductor layer ACT2 may be connected to other circuit elements, lines, and/or conductive patterns to function as the drain electrode and/or source electrode of the second transistor T2.

The second bottom gate electrode BG2 may be disposed on the buffer layer BUF and may be disposed on the same layer as the first bottom gate electrode BG1. The second bottom gate electrode BG2 may overlap the second semiconductor layer ACT2. For example, the second bottom gate electrode BG2 may be disposed on a lower side of the second semiconductor layer ACT2 to at least overlap the second channel region CH2. The first insulating layer INS1 and the second insulating layer INS2 may be disposed between the second bottom gate electrode BG2 and the second semiconductor layer ACT2. The second bottom gate electrode BG2 and the second semiconductor layer ACT2 may be spaced apart from each other by a distance corresponding to thicknesses of the first insulating layer INS1 and the second insulating layer INS2. The second bottom gate electrode BG2 may face the second top gate electrode GE2 with the second semiconductor layer ACT2 interposed therebetween.

The second bottom gate electrode BG2 may or may not be connected to one electrode of the second transistor T2. In an embodiment, the second bottom gate electrode BG2 may be connected to the second source electrode SE2 of the second transistor T2 and may be utilized as a back-gate electrode for adjusting the characteristics of the second transistor T2.

The second semiconductor layer ACT2 may be disposed on the second insulating layer INS2, may be disposed on the same layer as the first semiconductor layer ACT1, and may include the same oxide semiconductor as the first semiconductor layer ACT1.

The second semiconductor layer ACT2 may include a second channel region CH2 overlapping the second top gate electrode GE2, and a second drain region DR2 and a second source region SR2 spaced apart from each other with the second channel region CH2 interposed therebetween. For example, the second drain region DR2 and the second source region SR2 may be positioned on both sides of the second channel region CH2. The second channel region CH2 may be a region that is not conductive and maintains semiconductor properties, and the second drain region DR2 and the second source region SR2 may be conductive regions.

The second semiconductor layer ACT2 may overlap the second bottom gate electrode BG2 and the second top gate electrode GE2. For example, the second channel region CH2 of the second semiconductor layer ACT2 may be disposed between the second bottom gate electrode BG2 and the second top gate electrode GE2, and may overlap the second bottom gate electrode BG2 and the second top gate electrode GE2.

The second semiconductor layer ACT2 may be entirely covered by the third insulating layer INS3. For example, the second semiconductor layer ACT2 may be covered by the third insulating layer INS3 except for a portion where at least one contact hole (e.g., a third contact hole CNT3 and a fourth contact hole CNT4) is formed for connection to the second drain electrode DE2 and/or the second source electrode SE2. Accordingly, as the amount of hydrogen flowing into the second semiconductor layer ACT2 during the process of forming the panel circuit layer PCL is reduced, conductivity (e.g., carrier concentration) of the second semiconductor layer ACT2 and/or a formation length of the second channel region CH2 may be appropriately controlled.

The second top gate electrode GE2 may be disposed on the third insulating layer INS3 and may be disposed on the same layer as the first top gate electrode GE1.

The second top gate electrode GE2 may be disposed on the second semiconductor layer ACT2 to overlap the second channel region CH2. The second top gate electrode GE2 and the second semiconductor layer ACT2 may be spaced apart from each other with the third insulating layer INS3 interposed therebetween.

The second drain electrode DE2 and the second source electrode SE2 may be disposed on the fourth insulating layer INS4 and covered by the first passivation layer PVX1.

The second drain electrode DE2 may be connected to a portion of the second semiconductor layer ACT2. For example, the second drain electrode DE2 may be connected to the second drain region DR2 through the third contact hole CNT3 penetrating through the third insulating layer INS3 and the fourth insulating layer INS4.

The second source electrode SE2 may be connected to another portion of the second semiconductor layer ACT2. For example, the second source electrode SE2 may be connected to the second source region SR2 through the fourth contact hole CNT4 penetrating through the third insulating layer INS3 and the fourth insulating layer INS4. In an embodiment, the second source electrode SE2 may be further connected to the second bottom gate electrode BG2. For example, the second source electrode SE2 may be connected to the second bottom gate electrode BG2 through a fifth contact hole CNT5 penetrating through the first insulating layer INS1, the second insulating layer INS2, the third insulating layer INS3, and the fourth insulating layer INS4.

The pixel transistors TRS including the first transistor T1 and the second transistor T2, may be covered by at least one passivation layer. For example, the pixel transistors TRS may be covered by the first passivation layer PVX1 and the second passivation layer PVX2 as illustrated in FIG. 5.

In the embodiment illustrated in FIG. 5, the second transistor T2 of each pixel PX may be connected to the light emitting element ED of the corresponding pixel PX through the connection electrode CNE. The connection electrode CNE may be disposed on the first via layer VIA1 and covered by the second passivation layer PVX2. For example, the connection electrode CNE may be disposed between the first via layer VIA1 and the second passivation layer PVX2.

The connection electrode CNE may be connected to one electrode of the second transistor T2. As an example, the connection electrode CNE may be disposed on the second source electrode SE2 and be connected to the second source electrode SE2 through at least one contact hole or via hole penetrating through the first passivation layer PVX1 and the first via layer VIA1.

Each of the electrodes, conductive patterns, and/or lines provided on the conductive layers of the panel circuit layer PCL may include at least one conductive material, and may have a single-layer or multi-layer structure. For example, the first and second bottom gate electrodes BG1 and BG2, the first and second top gate electrodes GE1 and GE2, the first and second source electrodes SE1 and SE2, the first and second drain electrodes DE1 and DE2, and the connection electrode CNE may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), and other metals, an alloy thereof, or other conductive materials, and may each have a single-layer or multi-layer structure.

In an embodiment, the first and second semiconductor layers ACT1 and ACT2 may include an oxide semiconductor. For example, the first and second semiconductor layers ACT1 and ACT2 may include at least one of zinc oxide (ZnO), zinc-tin oxide (ZTO), indium-zinc oxide (IZO), indium oxide (InO), titanium oxide (TiO), indium-gallium oxide (IGO), indium-gallium-zinc oxide (IGZO), indium-gallium-tin oxide (IGTO), indium-zinc-tin oxide (IZTO), and indium-tin-gallium-zinc oxide (ITGZO), or other oxide semiconductors. The oxide semiconductor used to form the oxide transistors including the first transistor T1 and the second transistor T2 is not limited to the materials exemplified above, and may be variously changed depending on the embodiments. In an embodiment, the first and second semiconductor layers ACT1 and ACT2 may include the same oxide semiconductor.

In an embodiment, the semiconductor layers of the pixel transistors TRS may be formed of an oxide semiconductor with high mobility (e.g., an oxide semiconductor with high mobility with high electron concentration (e.g., mobility of approximately 50 cm²/Vs or more)) such as indium-tin-gallium-zinc oxide (ITGZO) or indium-gallium oxide (IGO). When the pixel transistors TRS are formed of the oxide semiconductor with high mobility, it is possible to form each transistor at a fine size (e.g., a size including an active layer with a width and/or length ranging from approximately several micrometers to tens of micrometers) while appropriately securing the mobility of each transistor. Accordingly, even in a high-resolution display device with a relatively narrow area of the pixel area PXA, the pixel transistors TRS may be easily disposed and/or formed, and element characteristics and/or operating characteristics of the pixel transistors TRS may be appropriately secured. For example, even if a channel length of at least one switching transistor provided in the pixel PX is reduced, operating characteristics (e.g., appropriate switching characteristics) of the switching transistor may be secured. Accordingly, the area occupied by the pixel transistors TRS may be appropriately and/or easily reduced, and a design space for other circuit elements or lines, etc. may be secured. Additionally, as the pixel transistors TRS are formed of the oxide semiconductor with high mobility, power consumption of the display device 10 may be reduced.

The light emitting element layer LEL may be disposed on the panel circuit layer PCL and may be positioned in the display area DA. For example, the light emitting element layer LEL may be disposed on the panel circuit layer PCL in the display area DA.

The light emitting element layer LEL may include light emitting elements ED of the pixels PX. For example, the light emitting element layer LEL may include a pixel defining film PDL (also referred to as a "bank") that partitions a light emitting area of each of the pixels PX and a light emitting element ED positioned in each light emitting area. In an embodiment, the light emitting element layer LEL may further include a spacer SPC disposed on a portion of the pixel defining film PDL.

Each light emitting element ED may include a first electrode PE (e.g., an anode electrode) connected to at least one pixel transistor TRS (e.g., the second transistor T2) included in the corresponding pixel PX, and a light emitting layer EML and a second electrode CE (e.g., a cathode electrode) that are sequentially disposed on the first electrode PE. In an embodiment, the light emitting element ED may further include a first functional layer (e.g., a hole layer including a hole transporting layer) interposed between the first electrode PE and the light emitting layer EML, and a second functional layer (e.g., an electron layer including an electron transporting layer) interposed between the light emitting layer EML and the second electrode CE.

The first electrode PE of the light emitting element ED may be disposed on the panel circuit layer PCL. In the embodiment illustrated in FIG. 5, the first electrode PE may be disposed on the second via layer VIA2 to correspond to each light emitting area, and may be connected to the connection electrode CNE through at least one contact hole or via hole penetrating through the second passivation layer PVX2 and the second via layer VIA2.

The first electrode PE may include a conductive material. In an embodiment, the first electrode PE may include a metal material with high reflectivity. For example, the first electrode PE may have a single layer structure of molybdenum (Mo), titanium (Ti), copper (Cu), and aluminium (Al), or may have a multi-layer structure (e.g., ITO/Mg, ITO/MgF, ITO/Ag, ITO/Ag/ITO, etc.) including indium-tin-oxide (ITO), indium-zinc-oxide (IZO), zinc oxide (ZnO), indium oxide (In₂O₃), and silver (Ag), magnesium (Mg), aluminium (Al), platinum (Pt), lead (Pb), gold (Au), or nickel (Ni).

The light emitting layer EML of the light emitting element ED may include a polymer material or a low molecular weight material. Light emitted from the light emitting layer EML may contribute to displaying an image. In an embodiment, the light emitting layer EML may be provided for each pixel PX, and the light emitting layer EML of each pixel PX may emit visible light of a color corresponding to the corresponding pixel PX. In another embodiment, the light emitting layer EML may be a common layer shared by pixels PX of different colors, and wavelength conversion layers and/or color filters corresponding to the color (or wavelength band) of light to be emitted from each pixel PX may be disposed in the light emitting areas of at least some of the pixels PX.

The second electrode CE of the light emitting element ED may include a conductive material. In an embodiment, the second electrode CE may be a common film formed over the entire display area DA to cover the light emitting layer EML and the pixel defining film PDL. In an embodiment, the second electrode CE may be formed of a transparent conductive material (TCO) such as ITO, IZO, ZnO, or ITZO capable of transmitting light, or a semi-transmissive conductive material such as magnesium (Mg), silver (Ag), or an alloy of magnesium (Mg) and silver (Ag).

The pixel defining film PDL may have an opening corresponding to each light emitting area and may surround the light emitting area. For example, the pixel defining film PDL may be formed to cover an edge of the first electrode PE of the light emitting element ED and may include an opening that exposes the remaining portion of the first electrode PE. An area where the exposed first electrode PE and the light emitting layer EML overlap (or an area including the same) may be defined as a light emitting area of each pixel PX.

In an embodiment, the pixel defining film PDL may include at least one organic insulating layer including an organic insulating material. For example, the pixel defining film PDL may include an acryl resin, an epoxy resin, a phenolic resin, a polyamides resin, a polyimides resin, an unsaturated polyesters resin, a poly phenyleneethers resin, a polyphenylenesulfides resin, or benzocyclobutene (BCB), or other organic insulating materials.

The spacer SPC may be disposed on a portion of the pixel defining film PDL. The spacer SPC may include at least one organic insulating layer including an organic insulating material. The spacer SPC may include the same material as the pixel defining film PDL or may include a different material from the pixel defining film PDL. In an embodiment, the pixel defining film PDL and the spacer SPC may be sequentially formed through each mask process. In another embodiment, the pixel defining film PDL and the spacer SPC may be simultaneously formed using a halftone mask. In this case, the pixel defining film PDL and the spacer SPC may be viewed as one insulating film that is integrated with each other.

The thin film encapsulation layer TFEL may be disposed on the light emitting element layer LEL. The thin film encapsulation layer TFEL may cover the light emitting element layer LEL in the display area DA and extend to the non-display area NDA to be in contact with the panel circuit layer PCL. For example, the thin film encapsulation layer TFEL may be disposed in the display area DA to cover the light emitting element layer LEL, and an end portion of the thin film encapsulation layer TFEL may be positioned in a portion of the non-display area NDA adjacent to the display area DA. The thin film encapsulation layer TFEL may block the permeation of oxygen or moisture into the light emitting element layer LEL, and may alleviate electrical and/or physical shock to the panel circuit layer PCL and the light emitting element layer LEL.

In an embodiment, the thin film encapsulation layer TFEL may have a multi-layer structure including a first encapsulation layer TFE1, a second encapsulation layer TFE2, and a third encapsulation layer TFE3 that are sequentially stacked on the light emitting element layer LEL. Each of the first encapsulation layer TFE1 and the third encapsulation layer TFE3 may be an inorganic encapsulation layer including an inorganic material. The second encapsulation layer TFE2 may be an organic encapsulation layer including an organic material. The structure and/or material of the thin film encapsulation layer TFEL may be changed depending on the embodiments.

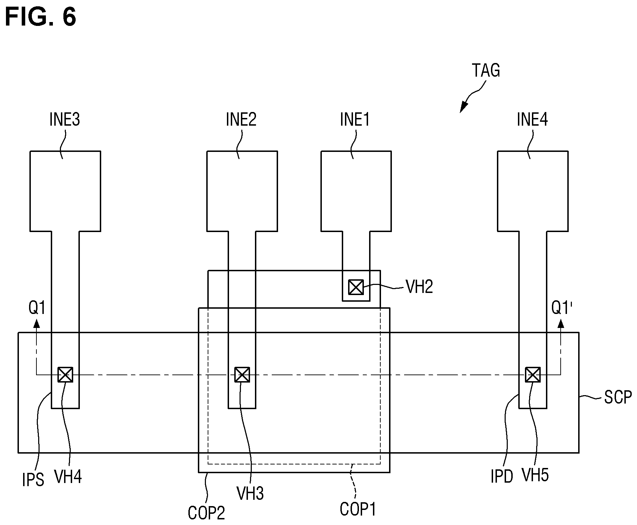

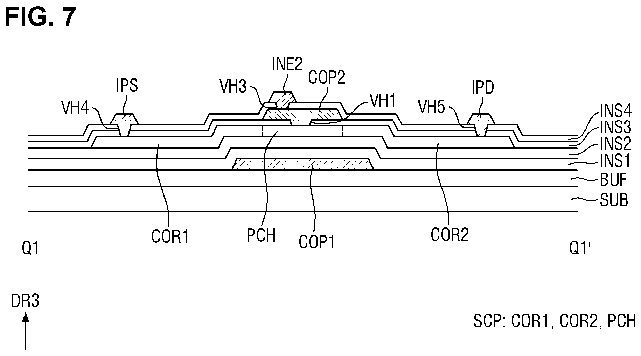

FIG. 6 is a plan view illustrating an inspection pattern according to an embodiment. FIG. 7 is a cross-sectional view taken along line Q1-Q1' of FIG. 6.

Referring to FIGS. 6 and 7, the inspection pattern TAG according to an embodiment may include a first conductive pattern COP1, a first inspection electrode INE1 connected to the first conductive pattern COP1, a semiconductor pattern SCP, a second conductive pattern COP2, a second inspection electrode INE2 connected to the second conductive pattern COP2, an inspection source electrode IPS connected to a portion of the semiconductor pattern SCP, a third inspection electrode INE3 connected to the inspection source electrode IPS, an inspection drain electrode IPD connected to another portion of the semiconductor pattern SCP, and a fourth inspection electrode INE4 connected to the inspection drain electrode IPD.

The first conductive pattern COP1 may be disposed on the substrate SUB. For example, the first conductive pattern COP1 may be disposed on the substrate SUB on which the buffer layer BUF is formed, and may be directly disposed on the buffer layer BUF.

The first conductive pattern COP1 may be disposed on the same layer as the bottom gate electrode BG of the panel circuit layer PCL illustrated in FIG. 5. For example, the first conductive pattern COP1 may be formed simultaneously with the bottom gate electrode BG through the same process.

A first insulating layer INS1 and a second insulating layer INS2 may be disposed on the first conductive pattern COP1. The first insulating layer INS1 may be the first insulating layer INS1 of the panel circuit layer PCL, and the second insulating layer INS2 may be the second insulating layer INS2 of the panel circuit layer PCL. For example, the first insulating layer INS1 and the second insulating layer INS2 may extend from the display area DA to the non-display area NDA and may be disposed on the first conductive pattern COP1.

The semiconductor pattern SCP may be disposed on the second insulating layer INS2. The semiconductor pattern SCP may be directly disposed on the second insulating layer INS2. The semiconductor pattern SCP may be disposed on the same layer as the first semiconductor layer ACT1 and the second semiconductor layer ACT2 of the panel circuit layer PCL. For example, the semiconductor pattern SCP may be formed simultaneously with the first semiconductor layer ACT1 and the second semiconductor layer ACT2 through the same process.

The semiconductor pattern SCP may include an oxide semiconductor. For example, the semiconductor pattern SCP may include the oxide semiconductors illustrated in the first semiconductor layer ACT1 and the second semiconductor layer ACT2 of the panel circuit layer PCL.

The semiconductor pattern SCP may include a first conductive region COR1, a pattern channel region PCH, and a second conductive region COR2. The pattern channel region PCH may overlap the second conductive pattern COP2. The first conductive region COR1 and the second conductive region COR2 may be spaced apart from each other with the pattern channel region PCH interposed therebetween. For example, the first conductive region COR1 and the second conductive region COR2 may be positioned on both sides of the pattern channel region PCH. The pattern channel region PCH may be a region that is not conductive and maintains semiconductor properties, and the first conductive region COR1 and the second conductive region COR2 may be conductive regions.

A third insulating layer INS3 may be disposed on the semiconductor pattern SCP. The third insulating layer INS3 may be the third insulating layer INS3 of the panel circuit layer PCL. For example, the third insulating layer INS3 may extend from the display area DA to the non-display area NDA and may be disposed on the semiconductor pattern SCP.

The second conductive pattern COP2 may be disposed on the third insulating layer INS3. For example, the second conductive pattern COP2 may be disposed on the third insulating layer INS3 and covered by the fourth insulating layer INS4.

The second conductive pattern COP2 may be disposed on the same layer as the top gate electrodes GE1 and GE2 of the panel circuit layer PCL illustrated in FIG. 5. For example, the second conductive pattern COP2 may be formed simultaneously with the top gate electrodes GE1 and GE2 through the same process. The second conductive pattern COP2 may overlap the first conductive pattern COP1 and may be disposed to overlap the pattern channel region PCH of the semiconductor pattern SCP.

The second conductive pattern COP2 may be connected to a portion of the semiconductor pattern SCP. For example, the second conductive pattern COP2 may be connected to the semiconductor pattern SCP through a first via hole VH1 penetrating through the third insulating layer INS3. In some embodiments, the second conductive pattern COP2 may be in direct contact with an upper surface of the semiconductor pattern SCP. In some embodiments, the second conductive pattern COP2 may be in direct contact with the pattern channel region PCH of the semiconductor pattern SCP.

A fourth insulating layer INS4 may be disposed on the second conductive pattern COP2. The fourth insulating layer INS4 may be the fourth insulating layer INS4 of the panel circuit layer PCL. For example, the fourth insulating layer INS4 may extend from the display area DA to the non-display area NDA and may be disposed on the second conductive pattern COP2.

A first inspection electrode INE1, a second inspection electrode INE2, a third inspection electrode INE3, a fourth inspection electrode INE4, an inspection source electrode IPS, and an inspection drain electrode IPD may be disposed on the fourth insulating layer INS4. The first inspection electrode INE1, the second inspection electrode INE2, the third inspection electrode INE3, the fourth inspection electrode INE4, the inspection source electrode IPS, and the inspection drain electrode IPD may be disposed on the same layer as the first and second source electrodes SE1 and SE2 and the first and second drain electrodes DE1 and DE2 of the panel circuit layer PCL illustrated in FIG. 5, and may be formed simultaneously therewith through the same process.

The first inspection electrode INE1 may be disposed to overlap a portion of the first conductive pattern COP1. The first inspection electrode INE1 may be connected to a portion of the first conductive pattern COP1. For example, the first inspection electrode INE1 may be connected to the first conductive pattern COP1 through a second via hole VH2 penetrating through the first insulating layer INS1, the second insulating layer INS2, the third insulating layer INS3, and the fourth insulating layer INS4.

The second inspection electrode INE2 may be disposed to overlap a portion of the second conductive pattern COP2. The second inspection electrode INE2 may be connected to a portion of the second conductive pattern COP2. For example, the second inspection electrode INE2 may be connected to the second conductive pattern COP2 through a third via hole VH3 penetrating through the fourth insulating layer INS4.

The inspection source electrode IPS may be disposed to overlap a portion of the semiconductor pattern SCP. The inspection source electrode IPS may be connected to a portion of the semiconductor pattern SCP. For example, the inspection source electrode IPS may be connected to the first conductive region COR1 of the semiconductor pattern SCP through a fourth via hole VH3 penetrating through the third insulating layer INS3 and the fourth insulating layer INS4.

The third inspection electrode INE3 may be connected to the inspection source electrode IPS. For example, the third inspection electrode INE3 may be formed integrally with the inspection source electrode IPS. However, the present disclosure is not limited thereto, and the third inspection electrode INE3 may be formed separately from the inspection source electrode IPS and may be connected thereto through a via hole.

The inspection drain electrode IPD may be disposed to overlap another portion of the semiconductor pattern SCP. The inspection drain electrode IPD may be connected to another portion of the semiconductor pattern SCP. For example, the inspection drain electrode IPD may be connected to the second conductive region COR2 of the semiconductor pattern SCP through a fifth via hole VH5 penetrating through the third insulating layer INS3 and the fourth insulating layer INS4.

The fourth inspection electrode INE4 may be connected to the inspection drain electrode IPD. For example, the fourth inspection electrode INE4 may be formed integrally with the inspection drain electrode IPD. However, the present disclosure is not limited thereto, and the fourth inspection electrode INE4 may be formed separately from the inspection drain electrode IPD and may be connected thereto through a via hole.

The above-described inspection pattern TAG may be formed including the same semiconductor pattern SCP as the first and second semiconductor layers ACT1 and ACT2 of the first and second transistors T1 and T2 of the display area DA. Accordingly, characteristics of the pixel transistors TRS may be inferred by inspecting characteristics of the inspection pattern TAG.

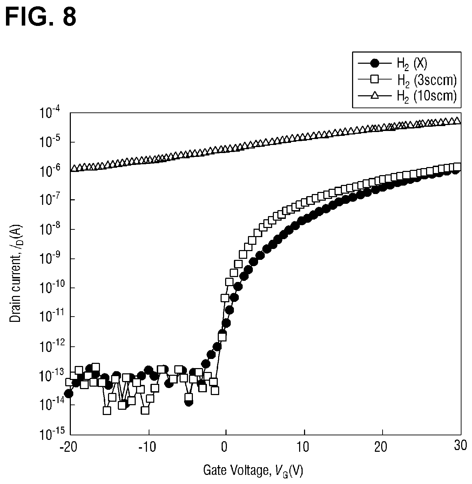

FIG. 8 is a graph illustrating changes in characteristics of a transistor depending on a hydrogen content of a semiconductor layer. For example, FIG. 8 illustrates electrical characteristics of transistors through a drain current Id according to a gate voltage Vg, in the transistors formed when hydrogen is not supplied, is supplied at 3 sccm (standard cubic centimeter per minute), and is supplied at 10 sccm, during the formation of the semiconductor layer.

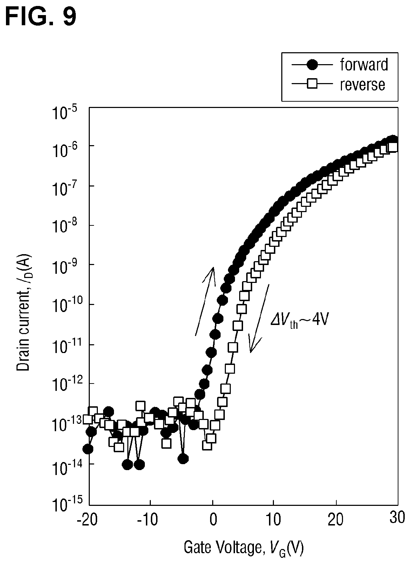

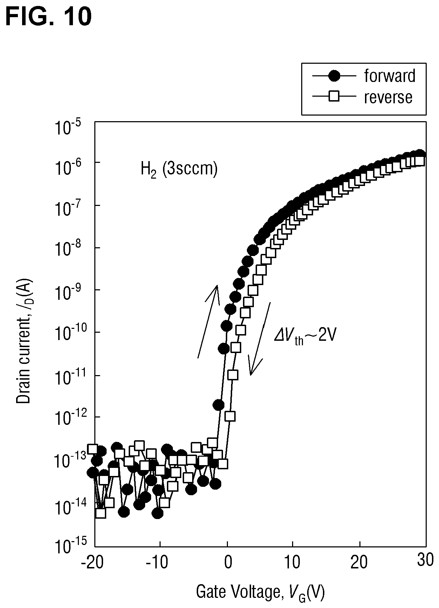

FIG. 9 is a graph illustrating changes in characteristics of a transistor having a semiconductor layer without hydrogen. FIG. 10 is a graph illustrating changes in characteristics of a transistor having a semiconductor layer containing hydrogen. For example, FIG. 9 illustrates a hysteresis curve of a transistor formed when hydrogen is not supplied during the formation of the semiconductor layer of FIG. 8, and FIG. 10 illustrates a hysteresis curve of a transistor formed when hydrogen is supplied at 3 sccm during the formation of the semiconductor layer of FIG. 8.

Referring to FIG. 8, when hydrogen is supplied, a threshold voltage Vth is approximately 3.82 and a subthreshold swing (SS) is approximately 1.89, and hydrogen is supplied at 3 sccm, a threshold voltage Vth is approximately 1.88 and a subthreshold swing (SS) is approximately 1.28. In addition, when hydrogen is supplied at 10 sccm, the semiconductor layer becomes conductive.

Referring to FIGS. 9 and 10, it was found that the hysteresis of the transistor containing hydrogen in the semiconductor layer was reduced compared to the transistor that did not contain hydrogen in the semiconductor layer.

It may be seen through FIGS. 8 to 10 that the hydrogen content of the semiconductor layer had a significant effect on the characteristics of the transistor.

Through this, the present inventors intend to maintain uniform display quality by inspecting and monitoring the characteristics of pixel transistors TRS in the display area DA even when the characteristics of pixel transistors TRS in the display area DA change depending on manufacturing process conditions, by inspecting the characteristics of the pixel transistor TRS through the inspection pattern TAG and confirming the hydrogen content of the semiconductor layer.

Hereinafter, a method of inspecting a display device including the inspection pattern TAG will be described with reference to FIGS. 1 to 7 described above.

Since the inspection pattern TAG includes an oxide pattern SCP, which is the same semiconductor layer as the pixel transistors TRS of the display area DA, the inspection pattern TAG represents the pixel transistors TRS in the display area DA, and the characteristics of the pixel transistor TRS in the display area DA may be confirmed using the inspection pattern TAG. For example, the characteristics of the transistor may be a capacitance value of the semiconductor layer.

In an embodiment, during the manufacturing process of the display device 10, a manufacturing process of the pixel transistor TRS of the panel circuit layer PCL and a manufacturing process of the inspection pattern TAG may be simultaneously performed. For example, the bottom gate electrode BG of the pixel transistor TRS and the first conductive pattern COP1 of the inspection pattern TAG, the semiconductor layers ACT1 and ACT2 of the pixel transistor TRS and the semiconductor pattern SCP of the inspection pattern TAG, the top gate electrodes GE1 and GE2 of the pixel transistor TRS and the second conductive pattern COP2 of the inspection pattern TAG, and the source and drain electrodes SE1, SE2, DE1, and DE2 of the pixel transistor TRS and the first to fourth inspection electrodes INE1, INE2, INE3, and INE4 of the inspection pattern TAG may be each simultaneously formed through the same process.

After the pixel transistor TRS and the inspection pattern TAG are formed, the inspection may be performed by connecting a measuring device to the inspection pattern TAG. The measuring device may be provided with terminals that may apply electric signals to the first to fourth inspection electrodes INE1, INE2, INE3, and IN4.

In an embodiment, a capacitance of a back channel of the semiconductor pattern SCP of the inspection pattern TAG may be measured. Here, the back channel of the semiconductor pattern SCP may refer to a channel formed on a lower side of the semiconductor pattern SCP adjacent to the first conductive pattern COP1. The capacitance of the back channel may be obtained by measuring a capacitance of the semiconductor pattern SCP while forming the back channel in the semiconductor pattern SCP.

As a method of forming the back channel in the semiconductor pattern SCP of the inspection pattern TAG, the back channel may be formed by applying an alternating current signal (e.g., frequency) to the first conductive pattern COP1 through the first inspection electrode INE1, and applying a direct current signal to the second conductive pattern COP2 through the second inspection electrode INE2 in the measuring device.

As described above, the second conductive pattern COP2 may be in direct contact with the upper surface of the semiconductor pattern SCP and be connected thereto. The third insulating layer INS3 is interposed between the second conductive pattern COP2 and the semiconductor pattern SCP. A tunneling effect does not occur between the second conductive pattern COP2 and the first conductive pattern COP1 even if the electrical signals are applied to the second conductive pattern COP2 and the first conductive pattern COP1 because the third insulating layer INS3 is thick. In the present embodiment, by directly contacting the second conductive pattern COP2 with the semiconductor pattern SCP, the tunneling effect may occur between the second conductive pattern COP2 and the first conductive pattern COP1. In the presence of an electron trap caused by hydrogen present in the semiconductor pattern SCP, current may travel through the trap due to the tunneling effect.

That is, when the electric signals are applied to the first conductive pattern COP1 and the second conductive pattern COP2, the current may flow between the first conductive pattern COP1 and the second conductive pattern COP2, and the current and capacitance within the semiconductor pattern SCP may be measured through the third inspection electrode INE3 and the fourth inspection electrode INE4.

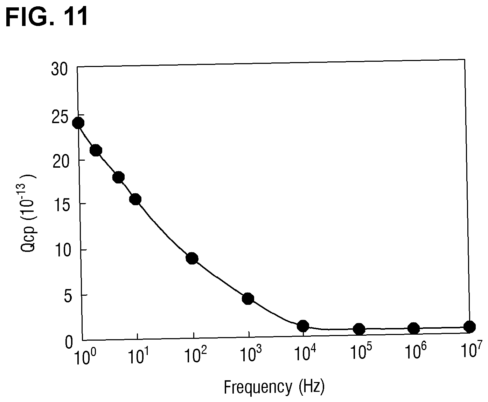

FIG. 11 is a graph illustrating a capacitance of a semiconductor pattern according to frequency. For example, FIG. 11 illustrates a capacitance of the semiconductor pattern SCP according to a frequency of the alternating current signal applied to the second conductive pattern COP2.

Referring to FIG. 11, as the frequency of the alternating current signal applied to the second conductive pattern COP2 increases, a capacitance Qcp of the semiconductor pattern SCP decreases.

In the present embodiment, a capacitance value of the semiconductor pattern SCP in which the back channel is formed may be measured using the inspection pattern TAG described above. Using such a capacitance value, a hydrogen content of the semiconductor pattern SCP may be found by comparing the capacitance value with a reference table in which the hydrogen content according to the capacitance value is analyzed.

Therefore, the characteristics of the pixel transistors TRS may be monitored by measuring the hydrogen content of the semiconductor pattern SCP using the inspection pattern TAG at regular intervals during the manufacturing of the display device 10.

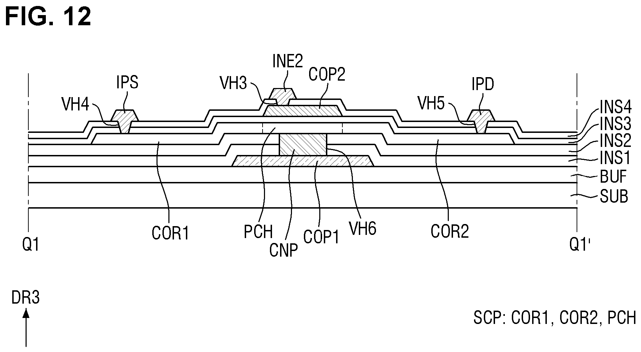

FIG. 12 is a cross-sectional view illustrating an inspection pattern of a display device according to another embodiment. FIG. 12 illustrates another embodiment of FIG. 7 described above.

Referring to FIG. 12, the present embodiment is different from the embodiment of FIG. 7 in that the inspection pattern TAG further includes a connection pattern CNP connecting the first conductive pattern COP1 and the semiconductor pattern SCP, and the second conductive pattern COP2 is spaced apart from the semiconductor pattern SCP. Hereinafter, descriptions of the same configuration as the above-described embodiment will be omitted and differences from the above-described embodiment will be described.

The inspection pattern TAG according to an embodiment may include a first conductive pattern COP1, a first inspection electrode INE1 connected to the first conductive pattern COP1, a connection pattern CNP connecting the first conductive pattern COP1 and a semiconductor pattern SCP, a semiconductor pattern SCP, a second conductive pattern COP2, a second inspection electrode INE2 connected to the second conductive pattern COP2, an inspection source electrode IPS connected to a portion of the semiconductor pattern SCP, a third inspection electrode INE3 connected to the inspection source electrode IPS, an inspection drain electrode IPD connected to another portion of the semiconductor pattern SCP, and a fourth inspection electrode INE4 connected to the inspection drain electrode IPD.

The connection pattern CNP may be disposed on the first conductive pattern COP1. For example, the connection pattern CNP may be disposed in direct contact with the first conductive pattern COP1. The connection pattern CNP may overlap the semiconductor pattern SCP and may be disposed to overlap the pattern channel region PCH of the semiconductor pattern SCP. The connection pattern CNP may be disposed in a sixth via hole VH6 penetrating through the first insulating layer INS1 and the second insulating layer INS2. The sixth via hole VH6 may be disposed to overlap the first conductive pattern COP1, the second conductive pattern COP2, and the semiconductor pattern SCP. The connection pattern CNP may be connected to the first conductive pattern COP1 and the semiconductor pattern SCP through the sixth via hole VH6. For example, the connection pattern CNP may be in direct contact with a lower surface of the pattern channel region PCH. The first conductive pattern COP1, the second conductive pattern COP2, and the connection pattern CNP may be disposed to overlap the pattern channel region PCH of the semiconductor pattern SCP.

The connection pattern CNP may be disposed in contact with side surfaces of the first insulating layer INS1 and the second insulating layer INS2. In some embodiments, an upper surface of the connection pattern CNP may be aligned with an upper surface of the second insulating layer INS2. However, the present disclosure is not limited thereto, and at least a portion of the connection pattern CNP may also be disposed to extend to the upper surface of the second insulating layer (INS2).

The connection pattern CNP may include a conductive material. For example, the connection pattern CNP may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), and other metals, an alloy thereof, or other conductive materials, and may each have single layer or multi-layer structure.

The semiconductor pattern SCP may be disposed on the connection pattern CNP and the second insulating layer INS2, and the third insulating layer INS3 may be disposed on the semiconductor pattern SCP. The second conductive pattern COP2 may be disposed on the third insulating layer INS3 overlapping the semiconductor pattern SCP. Unlike FIG. 7, the second conductive pattern COP2 may be disposed to be spaced apart from the semiconductor pattern SCP.

In an embodiment, a capacitance of a front channel of the semiconductor pattern SCP of the inspection pattern TAG may be measured. Here, the front channel of the semiconductor pattern SCP may refer to a channel formed on an upper side of the semiconductor pattern SCP adjacent to the second conductive pattern COP2. Accordingly, the front channel may be formed by contacting the first conductive pattern COP1 with the semiconductor pattern SCP through the connection pattern CNP and disposing the second conductive pattern COP2 to be spaced apart from the semiconductor pattern SCP.

The capacitance of the front channel may be obtained by measuring a capacitance of the semiconductor pattern SCP while forming the back channel in the semiconductor pattern SCP. As a method of forming the front channel in the semiconductor pattern SCP of the inspection pattern TAG, the front channel may be formed by applying a direct current signal to the first conductive pattern COP1 through the first inspection electrode INE1, and applying an alternating current signal (e.g., frequency) to the second conductive pattern COP2 through the second inspection electrode INE2 in the measuring device. In the present embodiment, a tunneling effect may occur between the second conductive pattern COP2 and the first conductive pattern COP1 by directly connecting the first conductive pattern COP1 to the semiconductor pattern SCP through the connection pattern CNP.

Therefore, when the electric signals are applied to the first conductive pattern COP1 and the second conductive pattern COP2, the current may flow between the first conductive pattern COP1 and the second conductive pattern COP2, and the current and capacitance within the semiconductor pattern SCP may be measured through the third inspection electrode INE3 and the fourth inspection electrode INE4.

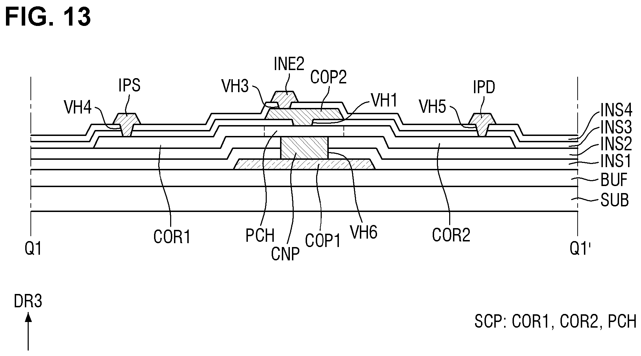

FIG. 13 is a cross-sectional view illustrating an inspection pattern of a display device according to still another embodiment. FIG. 13 illustrates an embodiment different from those of FIGS. 7 and 12 described above.

Referring to FIG. 13, the present embodiment illustrates an inspection pattern TAG including the structures of the embodiments of FIGS. 7 and 12 together. For example, the present embodiment is different from the above-described embodiments in that the inspection pattern TAG includes a connection pattern CNP connecting the first conductive pattern COP1 and the semiconductor pattern SCP, and the second conductive pattern COP2 is in contact with the semiconductor pattern SCP.

In an embodiment, a capacitance of a dual channel of the semiconductor pattern SCP of the inspection pattern TAG may be measured. Here, the dual channel of the semiconductor pattern SCP may refer to both the front channel formed on the upper side of the semiconductor pattern SCP adjacent to the second conductive pattern COP2 and the back channel formed on the lower side of the semiconductor pattern SCP adjacent to the first conductive pattern COP1. Accordingly, the dual channel may be formed by contacting the first conductive pattern COP1 with the semiconductor pattern SCP through the connection pattern CNP and contacting the second conductive pattern COP2 with the semiconductor pattern SCP.

The capacitance of the dual channel may be obtained by measuring a capacitance of the semiconductor pattern SCP while forming the front channel and the back channel in the semiconductor pattern SCP. As a method of forming the dual channel in the semiconductor pattern SCP of the inspection pattern TAG, the dual channel may be formed by applying an alternating current signal (e.g., frequency) to the first conductive pattern COP1 through the first inspection electrode INE1, and applying an alternating current signal (e.g., frequency) to the second conductive pattern COP2 through the second inspection electrode INE2 in the measuring device.

In the present embodiment, a tunneling effect may occur between the second conductive pattern COP2 and the first conductive pattern COP1 by directly connecting the first conductive pattern COP1 to the semiconductor pattern SCP through the connection pattern CNP and connecting the second conductive pattern COP2 to the semiconductor pattern SCP. Therefore, when the electric signals are applied to the first conductive pattern COP1 and the second conductive pattern COP2, the current may flow between the first conductive pattern COP1 and the second conductive pattern COP2, and the current and capacitance within the semiconductor pattern SCP may be measured through the third inspection electrode INE3 and the fourth inspection electrode INE4.

Therefore, the characteristics of the pixel transistors TRS may be monitored by measuring the capacitance of the semiconductor pattern SCP using the inspection pattern TAG at regular intervals during the manufacturing of the display device 10 and confirming the hydrogen content.

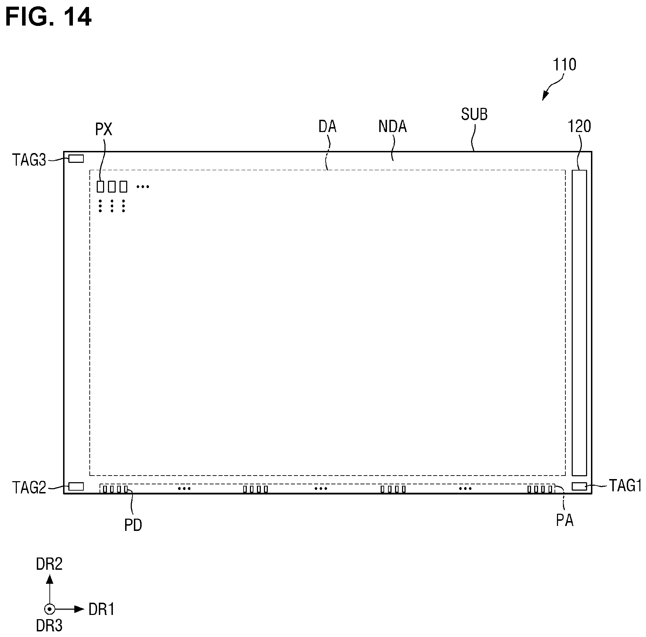

FIG. 14 is a plan view illustrating a display panel according to still another embodiment.

Referring to FIG. 14, the present embodiment is different from the embodiment of FIG. 2 described above in that the display panel includes a plurality of inspection patterns TAG1, TAG2, and TAG3.

The plurality of inspection patterns TAG1, TAG2, and TAG3 may be disposed in the non-display area NDA. For example, a first inspection pattern TAG1 may be disposed in a space between the first driver 120 and the pad area PA, and a second inspection pattern TAG2 may be disposed adjacent to the first inspection pattern TAG1 with the pad area PA interposed therebetween. A third inspection pattern TAG3 may be disposed on an upper left side of the display panel 110. However, the present disclosure is not limited thereto, and the plurality of inspection patterns TAG1, TAG2, and TAG3 may be disposed anywhere in the non-display area NDA. In addition, the plurality of inspection patterns TAG1, TAG2, and TAG3 may be disposed in the space between the first driver 120 and the pad area PA.

In an embodiment, the first inspection pattern TAG1 may be the inspection pattern illustrated in FIG. 7, the second inspection pattern TAG2 may be the inspection pattern illustrated in FIG. 11, and the third inspection pattern TAG3 may be the inspection pattern illustrated in FIG. 13. For example, the first inspection pattern TAG1 may be an inspection pattern that may measure the capacitance of the back channel, the second inspection pattern TAG2 may be an inspection pattern that may measure the capacitance of the front channel, and the third inspection pattern TAG3 may be an inspection pattern that may measure the capacitance of the dual channel.

In the present embodiments, the hydrogen content of the semiconductor pattern SCP may be analyzed by measuring the capacitances of various channels of the inspection pattern, including the plurality of inspection patterns TAG1, TAG2, and TAG3.

Although the embodiments of the present invention have been described above with reference to the accompanying drawings, it will be understood by those of ordinary skill in the art to which the present invention pertains that the present invention may be embodied in other specific forms without changing the technical spirit or essential characteristics of the present invention. Therefore, the embodiments described above are to be understood as illustrative in all respects and not restrictive.

## Claims

1. A display device comprising:
a substrate including a display area and a non-display area;
a transistor disposed on the display area of the substrate and including a semiconductor layer; and
at least one inspection pattern disposed on the non-display area of the substrate and including a semiconductor pattern,
wherein the inspection pattern includes:
a first conductive pattern and a second conductive pattern spaced apart from each other in a thickness direction with the semiconductor pattern interposed therebetween; and
an inspection source electrode connected to one portion of the semiconductor pattern and an inspection drain electrode connected to the other portion of the semiconductor pattern, and
the second conductive pattern is in contact with the semiconductor pattern.

2. The display device of claim 1, wherein the first conductive pattern further includes a first insulating layer and a second insulating layer that are disposed on the substrate and interposed between the semiconductor pattern and the first conductive pattern.

3. The display device of claim 1, wherein the semiconductor pattern includes a pattern channel region, and a first conductive region and a second conductive region spaced apart from each other with the pattern channel region interposed therebetween.

4. The display device of claim 3, wherein the first conductive pattern overlaps the pattern channel region.

5. The display device of claim 3, wherein the inspection source electrode is connected to the first conductive area, and the inspection drain electrode is connected to the second conductive area.

6. The display device of claim 1, wherein the second conductive pattern is disposed on the semiconductor pattern and overlaps the first conductive pattern.

7. The display device of claim 1, further comprising a third insulating layer disposed between the second conductive pattern and the semiconductor pattern,
wherein the second conductive pattern is in contact with the semiconductor pattern through a first via hole penetrating through the third insulating layer.

8. The display device of claim 1, further comprising a fourth insulating layer disposed between the inspection source electrode and the inspection drain electrode, and the second conductive pattern,
wherein the inspection source electrode and the inspection drain electrode are connected to the semiconductor pattern through a second via hole and a third via hole penetrating through the fourth insulating layer.

9. The display device of claim 1, further comprising:
a fourth insulating layer disposed on the second conductive pattern; and
a first inspection electrode, a second inspection electrode, a third inspection electrode, and a fourth inspection electrode disposed on the fourth insulating layer and spaced apart from each other.

10. The display device of claim 9, wherein the first inspection electrode is connected to the first conductive pattern, and the second inspection electrode is connected to the second conductive pattern.

11. The display device of claim 9, wherein the third inspection electrode extends from the inspection source electrode, and the fourth inspection electrode extends from the inspection drain electrode.

12. The display device of claim 1, wherein the semiconductor layer of the transistor in the display area includes the same material as the semiconductor pattern of the inspection pattern.

13. The display device of claim 12, wherein the semiconductor layer of the transistor in the display area and the semiconductor pattern of the inspection pattern include an oxide semiconductor.

14. The display device of claim 1, further comprising a connection pattern disposed between the first conductive pattern and the semiconductor pattern,
wherein the first conductive pattern is electrically connected to the semiconductor pattern through the connection pattern.

15. A display device comprising:
a substrate including a display area and a non-display area;
a transistor disposed on the display area of the substrate and including a semiconductor layer; and
an inspection pattern disposed on the non-display area of the substrate and including a semiconductor pattern,
wherein the inspection pattern includes:
a first conductive pattern and a second conductive pattern spaced apart from each other in a thickness direction with the semiconductor pattern interposed therebetween;
an inspection source electrode connected to one portion of the semiconductor pattern and an inspection drain electrode connected to the other portion of the semiconductor pattern; and
a connection pattern disposed between the first conductive pattern and the semiconductor pattern, and
the connection pattern is in contact with the first conductive pattern and the semiconductor pattern.

16. The display device of claim 15, wherein the semiconductor layer of the transistor in the display area and the semiconductor pattern of the inspection pattern include an oxide semiconductor.

17. The display device of claim 15, further comprising a first insulating layer and a second insulating layer interposed between the semiconductor pattern and the first conductive pattern,
wherein the connection pattern is disposed in a first via hole penetrating through the first insulating layer and the second insulating layer, and the first via hole overlaps the first conductive pattern and the semiconductor pattern.

18. The display device of claim 15, wherein the semiconductor pattern includes a pattern channel region, and a first conductive region and a second conductive region spaced apart from each other with the pattern channel region interposed therebetween, and
the connection pattern is in contact with the pattern channel region.

19. The display device of claim 18, wherein the first conductive pattern, the second conductive pattern, and the connection pattern overlap the pattern channel region of the semiconductor pattern.

20. The display device of claim 15, further comprising a third insulating layer disposed between the semiconductor pattern and the second conductive pattern,
wherein the second conductive pattern is spaced apart from the semiconductor pattern.
